# EUROPÄISCHE PATENTSCHRIFT

(11) **EP 0 904 548 B1**
(45) Veröffentlichungstag und Bekanntmachung des Hinweises auf die Patenterteilung: **21.08.2002**
(21) Anmeldenummer: 98916966.9
(22) Anmeldetag: 17.03.1998
(51) Int. Cl.: G01R 31/28

(54) **TESTSYSTEM UND TESTVERFAHREN**
TEST SYSTEM AND TEST METHOD
SYSTEME DE TEST ET PROCEDE DE TEST

(30) Priorität: 04.04.1997 DE 19713932
(43) Veröffentlichungstag der Anmeldung: 31.03.1999
(73) Patentinhaber: Omicron Electronics GmbH, 6844 Altach (AT)
(72) Erfinder: PETER, Winfried, A-6845 Hohenems (AT); HENSLER, Thomas, A-6833 Klaus (AT)
(74) Vertreter: Banzer, Hans-Jörg, Dipl.-Ing.
(86) Internationale Anmeldenummer: EP9801524
(87) Internationale Veröffentlichungsnummer: WO98045720

(56) Entgegenhaltungen:
- EP-A- 0 296 884
- EP-A- 0 336 656
- EP-A- 0 508 290
- HACHER: "Pc-messtechnik" ELEKTRONIK, Bd. 43, Nr. 10, 17.Mai 1994, Seiten 98-103, XP000450813
- "Datenlogger" ELEKTROTECHNIK, Bd. 70, Nr. 22, 16.Dezember 1988, WURZBURG, DE, Seiten 22-25, XP000111409
- DOUGLAS KIRSOP: "signal switching in automated test equipment" MACHINE DESIGN, Bd. 60, Nr. 29, Dezember 1988, CLEVELAND, OHIO, US, Seiten 75-80, XP000046804
- "le test a son atelier flexible" MESURES, Bd. 58, Nr. 655, Mai 1993, PARIS, FR, Seite 106-108 XP000363917
- THERRIEN E L: 'Wavetest - the total solution to GPIB test system programs' ELECTRO, US, ELECTRONIC CONVENTIONS MANAGEMENT Bd. 13, 10 Mai 1988 - 12 Mai 1988, LOS ANGELES, US, Seiten 45/4 1 - 45/4 4

## Beschreibung

Die vorliegende Erfindung betrifft ein Testsystem sowie ein Testverfahren zum Testen der Funktionsfähigkeit von elektrischen Bestandteilen von Energieversorgungseinrichtungen.

Zum Testen von elektrischen Prüflingen, insbesondere von elektrischen Bestandteilen von Energieversorgungseinrichtungen, sind verschiedene Arten von Testgeräten bzw. Testsystemen bekannt. Dabei stellen die bekannten Testsysteme in aller Regel lediglich Einzellösungen für bestimmte Anwendungsfälle dar und können lediglich bestimmte Funktionen einzelner Arten von Prüflingen testen. So sind beispielsweise auf dem Gebiet der Energieversorgungseinrichtungen separate Testgeräte für Überstrom-Relais, Synchronisiereinrichtungen, Energiezähler usw. bekannt.

Der Aufbau der zu testenden elektrischen Prüflinge wird jedoch zunehmend komplexer. So können beispielsweise die Prüflinge eine Vielzahl von Schutz- und Meßfunktionen enthalten, welche entsprechend getrennt geprüft werden müssen. Derartige multifunktionale Prüflinge lassen sich mit herkömmlichen Testsystemen nicht auf einfache Weise prüfen. Vielmehr müssen zum Prüfen der einzelnen Funktionen des Prüflings separate Testgeräte bereitgestellt werden.

Es ist zwar bekannt, mit ein und demselben Testsystem unterschiedliche Funktionen eines Prüflings zu testen; jedoch müssen diese einzelnen Funktionen des Prüflings getrennt voneinander geprüft werden, wobei es nicht möglich ist, während des Tests der einen Funktion auf die Testergebnisse der anderen Funktion zuzugreifen. Insbesondere kann keine Gesamtbeurteilung der Funktionsfähigkeit des Prüflings unter Berücksichtigung der Testergebnisse hinsichtlich sämtlicher geprüfter Funktionen abgegeben werden. Der von den bekannten Testsystemen erzeugte Testbericht, der die Testergebnisse eines Tests wiedergibt, enthält somit lediglich Aussagen über jeweils einen Funktionstest, d.h. der Testbericht bezieht sich jeweils nur auf einen Teilaspekt der Gesamtprüfung.

Die Zusammenstellung einer komplexen automatischen Prüfung, welche sämtliche Funktionen eines beispielsweise multifunktionalen Prüflings testet, ist nicht ohne vorherige Programmierung durch den Benutzer möglich. Dies hat jedoch zur Folge, daß eine derartige komplexe automatische Prüfung nicht ohne Programmierkenntnisse erstellt werden kann.

Aus der EP-A-0 508 290 ist ein Testsystem bekannt, welches insbesondere zum Testen eines Prüflings auf dem Gebiet der Funktechnik vorgesehen ist, umfaßt einen Prüfligsparameter-Speicher, in dem bestimmte Parameter aller zu testenden Prüflinge abgelegt sind, sowie einen Testgeräteparameter-Speicher, der alle zur Verfügung stehenden Testgeräte oder Testmodule sowie deren technischen Daten umfaßt. Der Benutzer besitzt die Möglichkeit, beispielsweise durch Auswahl eines entsprechenden Diagrammes mit anschließender benutzerspezifischen Beschriftung der Achsen des ausgewählten Diagrammes eine Testvorschrift zu erstellen, die im wesentlichen eine Aussage über den zu testenden Prüfling und den jeweils zu testenden Funktionsaspekt dieses Prüflings enthält. Anhand dieser Testvorschrift ermittelt ein Steuerrechner automatisch die hierzu benötigten Testgeräte und steuert diese entsprechend sequentiell an, um den gewünschten Test durchzuführen, wobei zudem ein entsprechender Verschaltungsplan angezeigt wird, der den Benutzer über die vorzunehmenden Verbindungen unterrichtet. Die auf diese Weise ermittelten Testergebnisse werden in einem Speicher gespeichert und auf einer Anzeige dargestellt. Mit Hilfe dieses Testsystems kann jedoch ein Benutzer lediglich einen bestimmten Funktionsaspekt eines einzigen Prüflings testen

Des weiteren offenbart die EP-A-0 296 884 ein Testsystem zum Testen von auf Leiterplatten montierten Bauteilen. Diese Druckschrift beschäftigt sich insbesondere mit dem Problem des Testens von Bauteilen, die ein relativ große Anzahl an Pins aufweisen. Hierzu werden mehrere unterschiedliche Tests nacheinander durchgeführt. Als erstes wird die physikalische .Ausrichtung der Pins in Bezug auf das Testgerät getestet. Anschließend wird die korrekte Verbindung der Pins des zu testenden Bauteils mit anderen Schaltungskomponenten der Leiterplatte getestet, was durch Anlegen entsprechender Anreizsignale über das Testgerät und Überwachung des infolge dieser Anreizsignale an einem bestimmten Schaltungsanschluß auftretenden Signals erfolgt. Schließlich wird zudem der Anschluß des Bauteils an die jeweilige Schaltung in Bezug auf mögliche unerwünschte Verbindungen (Kurzschlüsse etc.) getestet. Eine durch den Benutzer herbeigeführte Abänderung dieses Testablaufs bzw. das Testen anderer Funktionsaspekte ist jedoch nicht möglich.

Schließlich ist aus dem Dokument "PC-Meßtechnik: Eine Branche im Boom, 2. Teil", W. Hascher, ELEKTRONIK, Nr. 43/10, 17.05.1994, Seiten 98 bis 103, ein Testsystem nach dem Oberbegriff des Anspruches 1 bzw. ein Testverfahren nach dem Oberbegriff des Anspruches 14 für den Bereich der PC-Meßtechnik bekannt, wobei vorgeschlagen wird, durch Kombination bereitgestellter Testmodule, welche unterschiedliche Funktionsaspekte eines Prüflings testen können, eine benutzerspezifische Testvorschrift zu erstellen. Durch Ansteuern der einzelnen Testmodule gemäß der Testvorschrift können somit nacheinander unterschiedliche Funktionsaspekte eines Prüflings getestet werden, wobei automatisch ein Testbericht über die Ergebnisse der Einzeltests erstellt wird. Ein ähnliches Testsystem bzw. Testverfahren für GPIB - Tests ist in "Wavetest - the total solution to GPIB test system programs", Theorien E.L., ELECTRO, US, Electronic Conventions Management, Los Angeles, Vol. 13 (1988), Seiten 45/4-1 bis 4 bekannt.

Der vorliegenden Erfindung liegt die Aufgabe zugrunde, ein gegenüber diesem Stand der Technik verbessertes Testsystem und Testverfahren zum Testen der Funktionsfähigkeit von elektrischen Bestandteilen von Energieversorgungseinrichtungen vorzuschlagen.

Insbesondere soll ein Testsystem sowie ein Testverfahren vorgeschlagen werden, wobei selbst eine komplexe Prüfung eines derartigen Prüflings mit einfachen Mitteln gewährleistet ist. Des weiteren soll eine Gesamtbeurteilung des Gesamttests hinsichtlich der Funktionsfähigkeit des Prüflings möglich sein.

Die obengenannte Aufgabe wird hinsichtlich des Testsystems durch ein Testsystem nach Anspruch 1 und hinsichtlich des Testverfahrens durch ein Verfahren nach Anspruch 14 gelöst. Die Unteransprüche beschreiben allgemein vorteilhafte Ausgestaltungen der Erfindung.

Erfindungsgemäß stehen mehrere unterschiedliche Testmodule zur Verfügung, wobei jedes Testmodul einen bestimmten Prüfling hinsichtlich eines oder mehrerer Funktionsaspekte testet. Die einzelnen Testmodule können verschiedene Funktionsaspekte ein und desselben Prüflings oder unterschiedlicher Prüflinge testen. Bei den Prüflingen handelt es sich um elektrische Prüflinge von Energieversorgungseinrichtungen. Die einzelnen Testmodule werden benutzerspezifisch ausgewählt und kombiniert, so daß sich eine sequentielle Testvorschrift für den von dem Testsystem durchzuführenden Gesämttest ergibt. Insbesondere erfolgt die Auswahl der einzelnen Testmodule menügesteuert über eine graphische Benutzeroberfläche.

Nachdem ein Benutzer eine bestimmte Testfolge nach seinen Wünschen zusammengestellt hat, wird der Test durchgeführt, wobei die einzelnen in diese benutzerspezifische Testfolge eingebetteten Testmodule sequentiell angesteuert und aktiviert werden und somit ihren jeweils entsprechenden Funktionstest durchführen. Die Ergebnisse des Tests werden in einem Testbericht abgelegt.

Die Testvorschrift wird zusammen mit den für die Durchführung des entsprechenden Tests erforderlichen Parameterdaten abgespeichert, so daß durch erneutes Laden dieser Testvorschrift ein erneuter Test anhand der bereits erstellten benutzerspezifischen Testvorschrift durchgeführt werden kann. Der Testbericht, d.h. das Testprotokoll, wird in die benutzerspezifisch erstellte Testvorschrift eingebettet, so daß durch erneutes Laden dieser Testvorschrift nach Löschen sämtlicher oder einzelner eingetragener Testergebnisse ein erneuter Test anhand der gespeicherten Testvorschrift durchgeführt werden kann. Dies bedeutet, daß einerseits zurückliegende Testergebnisse später noch einmal eingesehen werden können und andererseits aufgrund archivierter Testergebnisse eine gleichartige Prüfung nochmals durchgeführt werden kann, da zusammen mit der früheren Testvorschrift bzw. dem Testbericht sämtliche fiir den zurückliegenden Test erforderlichen Parameterdaten abgespeichert worden sind.

Gemäß einem Ausführungsbeispiel der Erfindung stellt ein zentraler Prüflingsparameter-Speicher sämtliche Daten zur Verfügung, die den zu testenden Prüfling bzw. die zu testenden Prüflinge betreffen. Des weiteren ist ein zentraler Testgeräteparameter-Speicher vorgesehen, der sämtliche testgerätebezogenen Daten zur Verfügung stellt, welche die an das Testsystem angeschlossenen Testgeräte beschreiben. Durch Überprüfung der in dem Testgeräteparameter-Speicher abgelegten Daten kann somit das Testsystem automatisch beurteilen, ob die zur Verfügung stehenden Testgeräte für den benutzerspezifisch zusammengestellten Test ausreichend sind. Vorteilhafterweise können die durch den Benutzer ausgewählten Testmodule nicht nur in ihrer Gesamtheit, d.h. gemäß ihrer festgelegten Reihenfolge, ausgeführt werden, sondern sind auch einzeln ansteuerbar, was insbesondere für die Fehlersuche nach Auftreten eines Fehlers während des Gesamttests hilfreich ist.

Einzelne Funktionen des Testsystems können durch benutzerspezifische Zugriffscodes, welche in der Regel durch Passwörter gebildet sind, geschützt werden, so daß für einzelne Benutzer nur bestimmte Funktionen des Testsystems zugänglich sind. Für bestimmte Benutzer kann somit beispielsweise nur das Laden und Einsehen eines Testberichts möglich sein, ohne daß diese Benutzer eine eigene Prüfung oder ein Verändern des Testberichts bzw. der Testvorschrift durchführen können. Für andere Benutzer kann die Möglichkeit der Makro-Programmierung in dem Testsystem gesperrt sein.

Mit Hilfe der vorliegenden Erfindung kann auf einfache Weise eine komplexe Gesamtprüfung für einen beispielsweise multifunktionalen Prüfling benutzerspezifisch zusammengestellt werden, wobei der Prüfling in seiner Gesamtheit geprüft werden kann, d.h. sämtliche funktionalen Teilaspekte können innerhalb einer Prüfung getestet und zudem bewertet werden. Bei der Durchführung einer Prüfung wird automatisch ein Testbericht mit Testergebnissen in die Testvorschrift eingefügt, um nach Löschen einzelner oder Sämtliche Testergebnisse innerhalb der Testvorschrift einem erneuten Test mit den Testmodulen, für welche die Testergebnisse gelöscht worden sind, durchzuführen. Das Erstellen der benutzerspezifischen Testvorschrift erfolgt vorteilhafterweise über eine einfach zu bedienende graphische Benutzeroberfläche. Bereits durchgeführte Prüfungen können archiviert werden, so daß sich Testergebnisse historisch nachverfolgen lassen. Der automatisch erstellte Testbericht wird mit einer speziellen Ansicht dargestellt, so daß ein einfacher Vergleich mit bereits durchgeführten Prüfungen möglich ist.

Die Erfindung wird nachfolgend unter Bezugnahme auf die Zeichnung anhand bevorzugter Ausführungsbeispiele beschrieben.
- Fig. 1: zeigt ein vereinfachtes Blockschaltbild eines bevorzugten Ausführungsbeispiels des erfindungsgemäßen Testsystems,
- Fig. 2a und 2b: zeigen in dem in Fig. 1 dargestellten bevorzugten Ausführungsbeispiel auftretende Zustandsübergänge,
- Fig. 3: zeigt beispielhaft den Aufbau einer von dem erfindungsgemäßen Testsystem erstellten Testvorschrift,in welche Testprotokolle eingebettet sind,
- Fig. 4: zeigt ein Ausführungsbeispiel einer bei dem bevorzugten Ausführungsbeispiel verwendeten graphischen Benutzeroberfläche, und
- Fig. 5: zeigt eine weitere Darstellung der in Fig. 4 gezeigten graphischen Benutzeroberfläche.

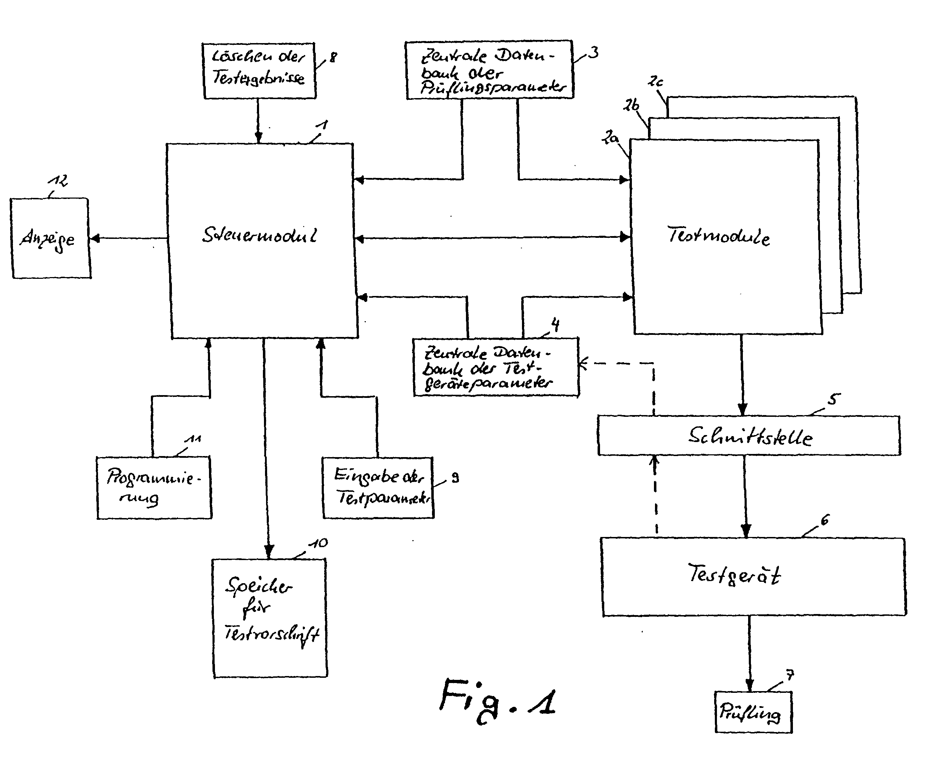

Fig. 1 zeigt ein vereinfachtes Blockschaltbild eines bevorzugten Ausführungsbeispiels des erfindungsgemäßen Testsystems, welches eine automatische Prüfung eines oder mehrerer Prüflinge mit integrierter Protokollierung und Archivierung der Testergebnisse bereitstellt.

Das in Fig. 1 gezeigte Testsystem umfaßt als wesentliche Bestandteile ein Steuermodul 1 sowie mehrere unterschiedliche Testmodule 2a - 2c. Die Testmodule 2a - 2c dienen jeweils zur Ansteuerung desselben oder unterschiedlicher Testgeräte, wobei in Fig. 1 lediglich ein Testgerät 6 dargestellt ist, welches über eine entsprechende Treiber-Schnittstelle 5 von den einzelnen Testmodulen 2a - 2c angesteuert wird. Die einzelnen Testmodule 2a - 2c können beispielsweise unterschiedliche Funktionen ein und desselben Prüflings 7 oder unterschiedliche Funktionen verschiedener Prüflinge 7 testen.

Eine zentrale Datenbank 3 dient zum Speichern und testmodul-übergreifenden Verwalten sämtlicher prüflingsbezogener Daten. Jedes zu prüfende Objekt, d.h. jeder Prüfling 7, ist modelliert, d.h. wird durch eine Vielzahl von verschiedenen Prüflingsparametern beschrieben, welche in der Datenbank 3 abgelegt sind. Dabei können zunächst nur die tatsächlich für die Prüfung erforderlichen prüflingsbezogenen Daten vorhanden sein, wobei der Datenumfang entsprechend später dynamisch anwachsen kann. Bei Prüflingen von Energieversorgungseinrichtungen kann es sich beispielsweise um ein Überstrom-Relais oder einen Energiezähler handeln. Des weiteren kann der Prüfling 7 eine Synchronisiereinrichtung sein, welche beim Zuschalten eines Generators an ein Versorgungsnetz erforderlich ist, um die Frequenz, die Spannung und die Phasenlage des Generators an das Versorgungsnetz anzupassen. Des weiteren kann es sich um einen multifunktionalen Prüfling handeln, wie z.B. einen multifunktionalen Abzweigschutz, der durch Überwachen des Stroms oder der Impedanz einer Abzweigleitung eines Versorgungsnetzes die Abzweigleitung selektiv abschalten kann. Die in der zentralen Datenbank 3 abgelegten prüflingsbezogenen Parameter können somit beispielsweise die Ein- oder Ausgänge (analog oder digital) der zu testenden Prüflinge sowie deren Funktionen beschreiben. Insbesondere können die prüflingsbezogenen Parameter einzelne Kennlinien, nominelle Strom- oder Spannungswerte oder die schaltungstechnische Umgebung des Prüflings, wie z.B. die Ansteuerung des Prüflings durch einen Transformator etc., betreffen. Die prüflingsbezogenen Parameterdaten der Datenbank 3 müssen vor Durchführen eines Tests durch einen Benutzer dem Testsystem mitgeteilt, d.h. eingegeben werden, wobei vorteilhafterweise diese Eingabe verteilt für die einzelnen Testmodule 2a - 2c erfolgt, insbesondere bei deren Einbettung in die Testvorschrift. Da diese Prüflingsparameterdaten vorzugsweise in einer Datei mit offenem, dokumentiertem Format gespeichert werden, ist es auch möglich, die Prüflingsparameterdaten softwaremäßig auszutauschen, wobei beispielsweise ein Hersteller eines bestimmten Prüflings bereits alle für den entsprechenden Prüfling notwendigen Parameterdaten in einer entsprechenden Datei speichert, die in die Datenbank 3 übernommen werden kann, so daß ein Benutzer die Prüflingsparameterdaten nicht nochmals eingeben muß. Auf die in der Datenbank 3 abgelegten Prüflingsparameterdaten greifen sowohl das Steuermodul 1 als auch die einzelnen Testmodule 2a - 2c zu, da diese Daten insbesondere für die Ausführung der einzelnen Testmodule und somit für die Ansteuerung des Testgeräts 6 erforderlich sind.

Des weiteren ist eine zweite zentrale Datenbank 4 für die testmodul-übergreifende Speicherung und Verwaltung von testgerätebezogenen Daten vorgesehen. Jedes anschließbare Testgerät 6 ist in seiner Gesamtheit modelliert, d.h. die die einzelnen Parameter dieses Testgeräts 6 beschreibenden Daten werden zentral in der Datenbank 4 verwaltet. Die in der Datenbank 4 abgelegten Testgeräteparameter betreffen sämtliche physikalischen Eigenschaften der einzelnen Testgeräte, wie beispielsweise Strom- oder Spannungsamplituden, die Anzahl der Meßein- und Ausgänge oder den auf jedem Testgerät zur Verfügung stehenden Speicherbereich. Insbesondere definieren die Testgerätparameter den Typ der einzelnen Testgeräte und geben an, ob beispielsweise mit den Testgeräten zusätzliche Verstärker oder andere Geräte verbunden sind. Die in der Datenbank 4 abgelegten Testgeräteparameter stehen sowohl dem Steuermodul 1 als auch den einzelnen Testmodulen 2a - 2c zur Verfügung, da auch diese Daten für die Ausführung der einzelnen Testmodule sowie die Ansteuerung der einzelnen Testgeräte über die Schnittstelle 5 erforderlich sind.

Die Datenbanken 3 und 4 können auch durch eine zentrale Datenverwaltung realisiert sein.

Wie bereits zuvor beschrieben worden ist, wird erfindungsgemäß vorgeschlagen, benutzerspezifisch einen Testablauf bzw. eine Testvorschrift durch benutzerspezifisches Auswählen und Kombinieren der einzelnen Testmodule 2a - 2c zu erzeugen. Nachdern diese Testvorschrift erstellt worden ist, steuert das Steuermodul 1 die einzelnen Testmodule 2a - 2c gemäß der den Wünschen des Benutzers entsprechend aufgestellten Testvorschrift 6 speziell an und aktiviert diese, so daß die einzelnen Testmodule 2a - 2c sequentiell Teiltests hinsichtlich eines Prüflings 7 oder verschiedener Prüflinge durchführen.

Gemäß einer bevorzugten Ausgestaltung der vorliegenden Erfindung wird zudem vorgeschlagen, daß vor Durchführung eines Gesamttests eine Überprüfung der Durchführbarkeit des Gesamttests durchgeführt wird. Dies erfolgt dadurch, daß das Steuermodul 1 vor Aktivieren der einzelnen Testmodule 2a - 2c gemäß der benutzerspezifischen Testvorschrift bzw. Testfolge die Anforderungen der von dem Benutzer für seine Testvorschrift ausgewählten Testmodule mit den tatsächlich verfügbaren, d.h. an das Testsystem angeschlossenen Testgeräten 6 vergleicht. Dies erfolgt insbesondere dadurch, daß das Steuermodul 1 auf die in der Datenbank 4 abgelegten Testgeräteparameterdaten zugreift. Mit Inbetriebnahme des Testsystems fragt das Testsystem über die Schnittstelle 5 automatisch sämtliche angeschlossene Testgeräte 6 sowie deren Testgeräteparameterdaten ab und legt die den als angeschlossen erkannten Testgeräten 6 entsprechenden Testgeräteparameterdaten in der Datenbank 4 ab, so daß die Datenbank 4 vor Ausführung eines Tests stets die Testgeräteparameterdaten sämtlicher zur Verfügung stehender Testgeräte 6 beinhaltet. Durch Zugriff auf die in der Datenbank 4 abgelegten Daten kann demnach das Steuermodul 1 in Verbindung mit den Testmodulen 2a - 2c entscheiden, ob die in der benutzerspezifischen Testvorschrift berücksichtigten Testmodule 2a - 2c mit Hilfe der durch die in der Datenbank 4 abgelegten Daten identifizierten angeschlossenen Testgeräte ausgeführt werden können. Ist dies nicht möglich, gibt das Steuermodul 1 eine entsprechende Warnung akustisch oder optisch über eine Anzeigenvorrichtung 12 aus. Zusätzlich kann das Steuermodul 1 optisch die für die Ausführung des Tests erforderlichen Testgeräte über die Anzeige 12 darstellen, so daß beispielsweise die für die Testdurchführung erforderliche Verdrahtung der einzelnen Testgeräte 6 wiedergegeben wird, um einem Benutzer die ordnungsgemäße Durchführung des von ihm benutzerspezifisch zusammengestellten Gesamttests zu erleichtern.

Mit Hilfe der zuvor beschriebenen Überprüfung der Verfügbarkeit der erforderlichen Testgeräte ist gewährleistet, daß für den Fall, daß die erforderlichen Testgeräte nicht an das Testsystern angeschlossen sind, bereits vor einer unter Umständen länge dauernden Prüfung entsprechende Maßnahmen getroffen werden und nicht erst während des Prüfablaufs, wenn eine entsprechende Fehlermeldung ausgegeben wird.

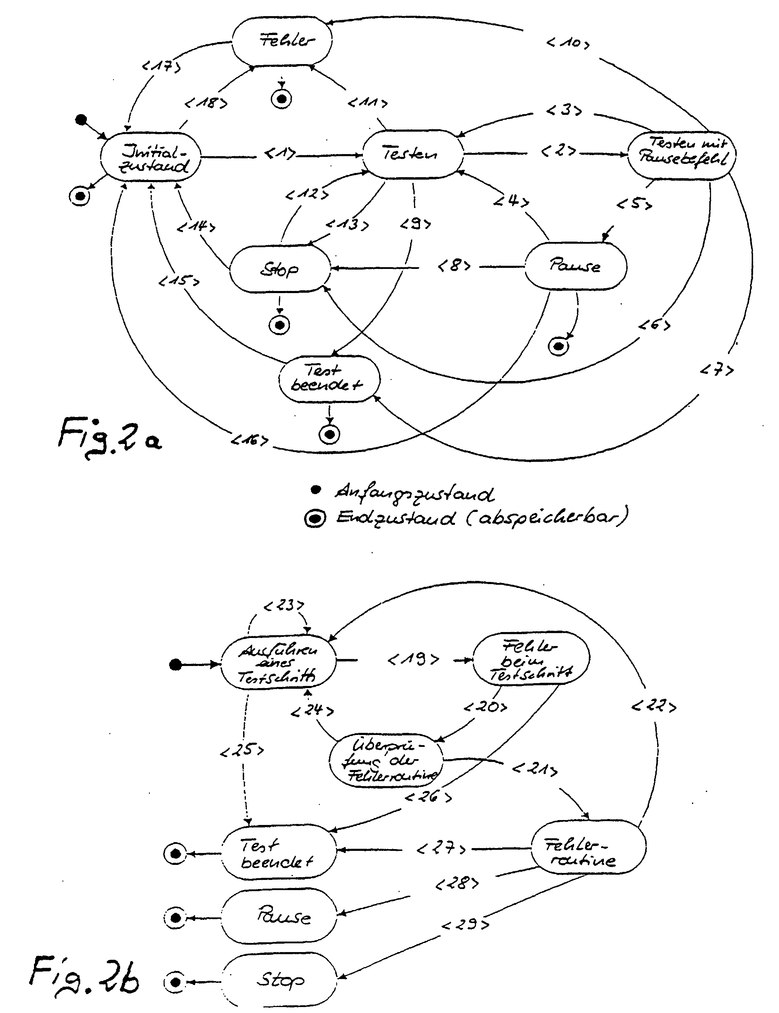

Um eine von dem Steuermodul 1 unabhängige Ausführung des Gesamttests zu gewährleisten, wird eine Zustandssteuerung verwendet, die sowohl in dem Steuermodul 1 als auch in den einzelnen Testmodulen 2a - 2c realisiert ist. Fig. 2a zeigt die dabei auftretenden einzelnen Zustände sowie die erlaubten Zustandsübergänge, wobei mit jedem Zustandsübergang eine entsprechende Mitteilung an das Steuermodul 1 verbunden ist, so daß das Steuermodul 1 ständig über den Zustand bzw. den Ablauf der Prüfung informiert ist und entsprechende Zustandsmeldungen ausgeben kann.

Wie in Fig. 2a gezeigt ist, wird ausgehend von dem "Initialzustand" durch die Ansteuerung der einzelnen Testmodule mit Hilfe des Steuermoduls in den Zustand "Testen" übergegangen (Zustandsübergang < 1 >). Der Testvorgang kann von dem Benutzer angehalten oder unterbrochen werden. Wird der Testvorgang von dem Benutzer lediglich angehalten (Zustandsübergang < 2 >), so schließt das Testsystem noch den laufenden Testschritt ab und geht erst dann in den "Pausezustand" über (Zustandsübergang < 5 >). Anschließend kann der Testvorgang wieder fortgesetzt werden (Zustandsübergang < 4>). Wird hingegen der Testvorgang von dem Benutzer unterbrochen (Zustandsübergang < 13 >), so wird der Testvorgang sofort abgebrochen und beendet ("Stoppzustand"). Auch eine unterbrochene Prüfung kann von dem Benutzer wieder fortgesetzt werden (Zustandsübergang < 12 >). Wurde ein Testvorgang von dem Benutzer lediglich angehalten, kann auch ausgehend von diesem Zustand die Prüfung unterbrochen und sofort beendet werden (Zustandsübergänge < 6 > und < 8 >). Der Zustandsübergang < 8 > kann auch entfallen. Konnte die Testfolge vollständig abgeschlossen werden, so wird in den Zustand "Test beendet" übergegangen (Zustandsübergänge < 7 > und < 9 >). Tritt hingegen ein Initialzustand oder während des Testens ein Fehler im System auf, wird über die Zustandsübergänge < 18 >, < 11 > und < 10 > eine Fehlerbehandlung durchgeführt. Ausgehend von den einzelnen in Fig. 2a dargestellten Zuständen kann der Benutzer wieder in den "Initialzustand" übergehen (Zustandsübergänge < 14 >, < 15 >, < 16 > und < 17 >), wobei damit jeweils ein Löschen der augenblicklichen Testergebnisse verbunden ist.

Unter Bezugnahme auf Fig. 2b soll nachfolgend die Fehlerbehandlung während des Testens beschrieben werden. Wie bereits zuvor erwähnt worden ist, wird fortlaufen eine Bewertung der Teilergebnisse des Tests durchgeführt, wobei bei einem fehlerfreien Teilergebnis der Test fortgesetzt wird (Zustandsübergang < 23 >) und bei einem fehlerhaften Teilergebnis in die Fehlerbehandlung übergegangen wird (Zustandsübergang < 19 >). Über den Zustandsübergang < 26 > kann der Benutzer entscheiden, daß er nach Auftreten eines Fehlers - beispielsweise um Zeit zu sparen - den Test sofort beenden will. Ansonsten wird überprüft, ob eine Fehlerroutine installiert ist (Zustandsübergang < 20 >) und - falls nicht - wieder mit dem Testzustand fortgefahren (Zustandsübergang < 24 >). Ist hingegen die Fehlerroutine installiert (Zustandsübergang < 21 >), so kann der Benutzer innerhalb dieser Fehlerroutine die weitere Durchführung der Prüfung selber bestimmen. Der Benutzer kann bestimmen, daß die Prüfung normal weitergeführt werden soll (Zustandsübergang < 22 >), daß die Prüfung angehalten wird (Zustandsübergang < 28 >) oder die Prüfung sofort abgebrochen wird (Zustandsübergang < 29 >), um die Prüfung beispielsweise später fortzusetzen, wenn nähere Untersuchungen hinsichtlich der Ursache des Fehlers durchgeführt worden sind. Ebenso kann der Benutzer jedoch auch festlegen, daß trotz Auftreten eines Fehlers die Prüfung als abgeschlossen zu betrachten ist (Zustandsübergang < 27 >), weil beispielsweise das Endergebnis der Prüfung bereits feststeht oder der Benutzer den Test trotz Auftreten eines Fehlers als "fehlerfrei" einstufen will. Über den Zustandsübergang < 25 > wird schließlich automatisch erkannt, daß der ausgeführte Testschritt der letzte Testschritt des Gesamttests ist, so daß in den Zustand "Test beendet" übergegangen wird.

Bei den in Fig. 2a und 2b dargestellten Zustandsdiagrammen wird hinsichtlich der einzelnen Zustände zwischen Anfangszuständen (dargestellt durch einen ausgefüllten schwarzen Kreis) und Endzuständen (dargestellt durch einen von einer Kreislinie umgebenen ausgefüllten schwarzen Kreis) unterschieden. Befindet sich das Testsystem in einem der Endzustände, so können in einem dieser Endzustände die Ergebnisse der Prüfung sowie die von dem Benutzer erstellte Testvorschrift mit sämtlichen für die Prüfung erforderlichen Parametern abgespeichert werden.

Aufgrund der in Fig. 2a und 2b dargestellten Zustandssteuerung ist gewährleistet, daß das Steuermodul 1 ständig über den Fortgang und den Zustand der Prüfung informiert ist, so daß entsprechende Zustandsmeldungen von dem Steuermodul 1 ausgegeben werden können, um den Benutzer entsprechend zu informieren.

Nachfolgend soll unter Bezugnahme auf Fig. 1 die Erstellung einer Testvorschrift gemäß dem erfindungsgemäßen Testverfahren näher erläutert werden.

Nach Inbetriebnahme des Testsystems wird zu Beginn das Steuermodul 1 gestartet und von dem Steuermodul 1 zunächst eine leere Testvorschrift, d.h. ein noch nicht ausgefülltes Prüfdokument, erstellt und auf einem als Anzeigeeinrichtung 12 dienenden Bildschirm dargestellt. In diese Testvorschrift kann der Benutzer über entsprechende Eingabemittel 9, beispielsweise ein Keyboard oder eine Maus, beliebige Texte eingeben, Formatieren oder Bearbeiten. Ebenso können andere Standardobjekte, wie beispielsweise ActiveX-Objekte (Grafiken, Tabellen) beliebig eingesetzt werden. Einzelne Testmodule, d.h. Teilprüfungen, werden durch den Benutzer in der gewünschten Reihenfolge ausgewählt und auf diese Weise in die von dem Steuermodul 1 erstellte Testvorschrift sequentiell eingefügt. Zwischen den einzelnen Testmodulen kann wiederum ein gewünschter Text oder Kommentar usw. eingegeben bzw. eingebettet werden. Mit dem Auswählen eines Testmoduls 2a - 2c wird automatisch von dem Steuermodul 1 ein von dem eingefügten Testmodul bereitgestellter Testbericht bzw. Testprotokoll an der entsprechenden Stelle in dem Prüfdokument eingefügt. Dieser testmodulspezifische Testbericht enthält zunächst noch keine Ergebnisse. Zugleich wird mit dem Einfügen eines Testmoduls 2a - 2c die Eingabe von Testparametern über die Eingabeeinrichtung 9 ermöglicht. Diese Testparameter sind für jedes Testmodul benutzerspezifisch einzugeben und legen den Testablauf, wie beispielsweise einzelne auszutestende Punkte, fest. Die Testparameter können beispielsweise durch automatisches Öffnen einer entsprechenden Eingabemaske eingegeben werden. An dieser Stelle können auch vom Benutzer weitere Prüflingsparameter eingegeben werden, um den Bestand der zentralen Prüflingsparameterverwaltung 3 zu ergänzen.

Nachdem auf diese Weise eine Testvorschrift bzw. ein Prüfdokument mit mehreren in beliebiger Reihenfolge angeordneten Testmodulen 2a - 2c von dem Benutzer erstellt worden ist, kann der Benutzer über das Steuermodul 1 den Test starten, wobei sowohl der Gesamttest als auch ein bestimmtes einzelnes Testrnodul ausgeführt werden kann. Insbesondere kann der Benutzer vor Starten des Tests auf einfache Art und Weise die tatsächlich auszuführenden Testmodule in der von ihm erstellten Testvorschrift auswählen. Die Testergebnisse werden automatisch auf der Anzeigeeinrichtung 12 angezeigt und können zudem ausgedruckt werden. Des weiteren werden die Testergebnisse automatisch von dem Steuermodul 1 in das von dem Benutzer erstellte Prüfdokument, d.h. in die Testvorschrift, übernommen, so daß der Benutzer die gesamte Testvorschrift zusammen mit den Testergebnissen in entsprechenden Speichermitteln 10, beispielsweise in einer Datenbank, abspeichern und ablegen kann.

Eine einmal durchgeführte Prüfung dient als Vorlage für eine neue Prüfung bzw. als Vorlage für eine erneute Durchführung derselben Prüfung. Zu diesem Zweck muß der Benutzer lediglich eine in den Speichermitteln 10 abgelegte ältere Testvorschrift laden und die darin abgelegten Testergebnisse - falls vorhanden - über entsprechend vorgesehene Löschmittel 8 löschen. Nach Löschen der alten Testergebnisse steht wieder die Testvorschrift in ihrer ursprünglichen Form zur Verfügung und kann insbesondere durch den Benutzer durch Auswahl weiterer Testmodule 2a - 2c bzw. durch Löschen bereits ausgewählter Testmodule ergänzt oder verändert werden. Dieses Verfahren ist insbesondere hilfreich, um einzelne Prüfungen miteinander zu vergleichen. Die von dem Benutzer zuletzt durchgeführte bzw. aus den Speichermitteln 10 geladene Prüfung bleibt vorteilhafterweise zunächst erhalten und wird neben der von dem Benutzer neu durchgeführten Prüfung auf der Anzeigeneinrichtung 12 dargestellt, so daß die einzelnen Prüfungen auf einfache Weise verglichen und insbesondere ein Trend bei der Prüfung erkannt werden kann.

Als Hilfsmittel für besonders komplexe Abläufe in dem Testsystem kann das Steuermodul 1 und/oder die einzelnen Testmodule 2a - 2c durch eine sogen. Makro-Programmierung (Basic Scripting) automatisiert werden. Dies geschieht über entsprechende Programmiermittel 11, wobei die Programmierung insbesondere über eine Tastatur erfolgen und abgerufen werden kann.

Wie bereits anhand Fig. 2a und 2b beschrieben worden ist, kann ein Benutzer über das Steuermodul 1 jedes Testmodul beliebig starten, stoppen oder pausieren. Des weiteren kann der Benutzer über die Löschmittel 8 bereits vorhandene Testergebnisse zurücksetzen, d.h. löschen. Vor Durchführen eines neuen Tests müssen zunächst bestehende Testergebnisse gespeichert oder gelöscht werden, um somit nicht die bestehenden Testergebnisse ungewollt zu überschreiben.

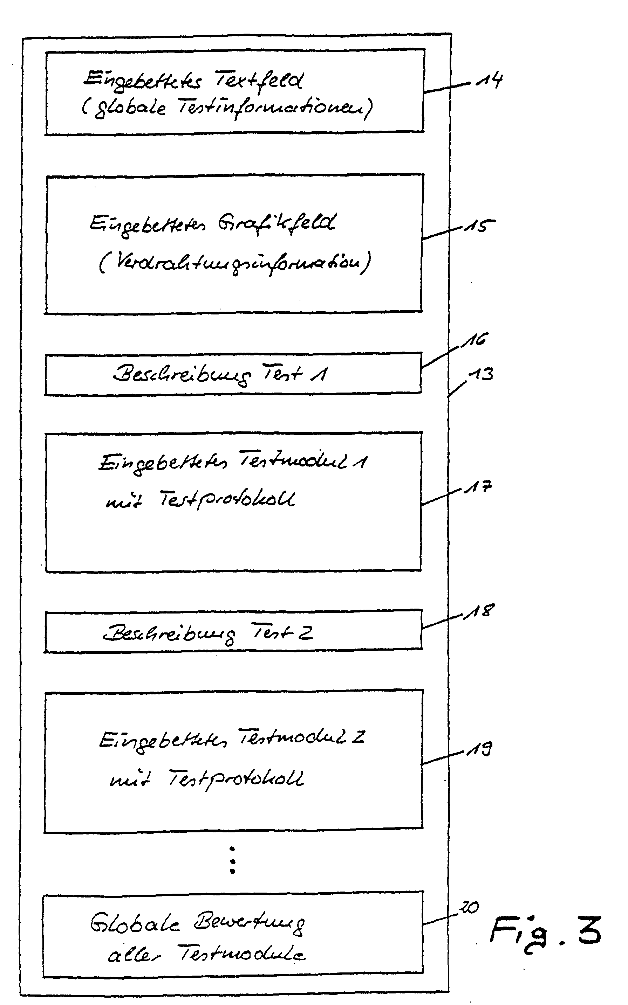

Fig. 3 zeigt ein Beispiel für eine von einem Benutzer erstellte Testvorschrift 13. Der Benutzer hat in die Testvorschrift 13, d.h. das entsprechende Prüfdokument, zunächst ein erstes Textfeld 14 eingefügt, welches beispielsweise globale Testinformationen über die Person des Benutzers, das Testobjekt, das Testdatum usw. enthalten kann. Anschließend hat der Benutzer ein Grafikfeld 15 eingebettet, wobei das Steuermodul 1 vorteilhafterweise dieses Grafikfeld 15 automatisch erzeugt und darin Verdrahtungsinformationen für den Benutzer hinsichtlich des Anschlusses seiner Testgeräte an dem Prüfling enthält. Dieses Grafikfeld 15 wird insbesondere von dem Steuermodul 1 erst nach Auswählen einzelner Testmodule erstellt, wobei bei Auswahl eines Testmoduls das Steuermodul durch Zugriff auf die in Fig. 1 dargestellte zentrale Datenbank 4 mit den darin abgelegten Testgeräteparameterdaten die notwendige Verdrahtung des entsprechenden Testgeräts ermittelt und in dem Grafikfeld 15 anzeigt. Anschließend hat der Benutzer einen weiteren Text 16 eingegeben, welcher beispielsweise als Überschrift und Definition des nachfolgend von ihm ausgewählten ersten Testmoduls 17 dient. Nach Auswahl des ersten Testmoduls 17 wird dieses automatisch von dem Steuermodul in die Testvorschrift 13 eingebettet und in Form eines Testprotokolls in der Testvorschrift 13 wiedergegeben, wobei der Benutzer den Umfang der Darstellung dieses Testprotokolls bestimmen kann. Auf diese Weise kann der Benutzer festlegen, welche Testergebnisse des entsprechenden Testmoduls für ihn tatsächlich interessant sind. Auf ähnliche Weise können weitere Testüberschriften 18 und weitere Testmodule 19 eingefügt werden. Am Ende der Testvorschrift wird automatisch von dem Steuermodul eine übergreifende Statistik 20, d.h. eine globale Bewertung sämtlicher von dem Benutzer eingebetteter Testmodule 17 und 19 erzeugt und eingefügt, welche beispielsweise Informationen über die Anzahl der eingefügten Testmodule, die Anzahl der getesteten Testmodule, die Anzahl der fehlerfreien Testmodule und die Anzahl der fehlerhaften Testmodule beinhaltet. Vorteilhafterweise kann beispielsweise vor der Verdrahtungsinformation 15 von der zentralen Prüflingsparameterverwaltung auch ein Informationsfeld über die Prüflingsparameter des Tests eingefügt werden.

Auf diese Weise kann mit Hilfe des erfindungsgemäßen Testsystems einfach ein komplexer Prüfablauf von einem Benutzer gemäß seinen speziellen Anforderungen erstellt und eine globale Gesamtbewertung des von ihm festgelegten Gesamttests ermittelt werden.

Die in Fig. 3 beispielhaft dargestellte Testvorschrift wird von dem Benutzer - wie bereits beschrieben worden ist - abgespeichert, wobei zusammen mit der Testvorschrift die möglicherweise innerhalb der einzelnen Testprotokolle enthaltenen Testergebnisse sowie die in der Testvorschrift eingebetteten Testmodule abgelegt und gespeichert werden. Des weiteren werden zusammen mit der Testvorschzift 13 die für die einzelnen Testmodule eingegebenen Testparameter und vorteilhafterweise auch die für die Durchführung der eingebetteten Testmodule aus den Datenbanken 3 und 4 ausgelesenen Prüflingsparameter und Testgeräteparameter gespeichert, so daß nach Laden der Testvorschrift 13 dieselbe Prüfung erneut problemlos durchgeführt werden kann. Vor Durchführen derselben Prüfung müssen jedoch über die Löschmittel 8 die zuletzt ermittelten Testergebnisse gelöscht werden. Da zwischenzeitlich auch andere oder neue Testgeräte an das Testsystem angeschlossen sein können, wird die Datenbank 4, welche sämtliche Testgeräteparameter der an das Testsystem angeschlossenen Testgeräte beinhaltet, ständig aktualisiert, d.h. die an die Schnittstelle 5 angeschlossenen Testgeräte 6 werden ständig überprüft und die entsprechenden Testgeräteparameter in der Datenbank 4 abgelegt. Beim Starten eines neuen Tests können dann die Testmodule auf die jeweils aktuellen Testgeräteparameter zugreifen.

Das der vorliegenden Erfindung zugrundeliegende Prinzip wurde zuvor allgemein unter Bezugnahme auf Fig. 1 bis 3 anhand eines beliebigen Prüflings 7 erläutert, wobei der Prüfling 7 insbesondere ein multifunktionaler elektrischer Prüfling sein kann, der somit mehrere Funktionen zur Verfügung stellt.

Die vorliegende Erfindung wird zum Testen der Funktionsfähigkeit von Energieversorgungseinrichtungen bzw. deren Bestandteile eingesetzt. Des weiteren ist das erfindungsgemäße Testsystem bzw. das erfindungsgemäße Testverfahren bevorzugt rechnergestützt realisiert, wobei der Benutzer vorteilhafterweise menügesteuert über eine graphische Benutzeroberfläche mit dem Testsystem kommunizieren kann.

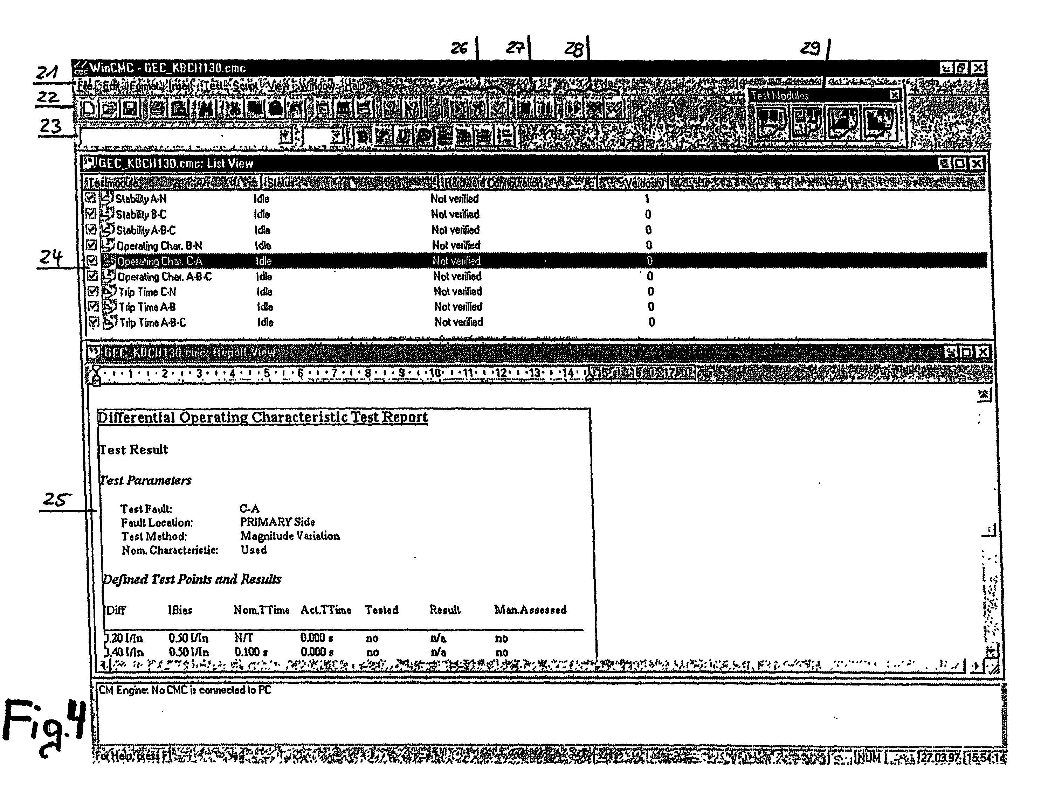

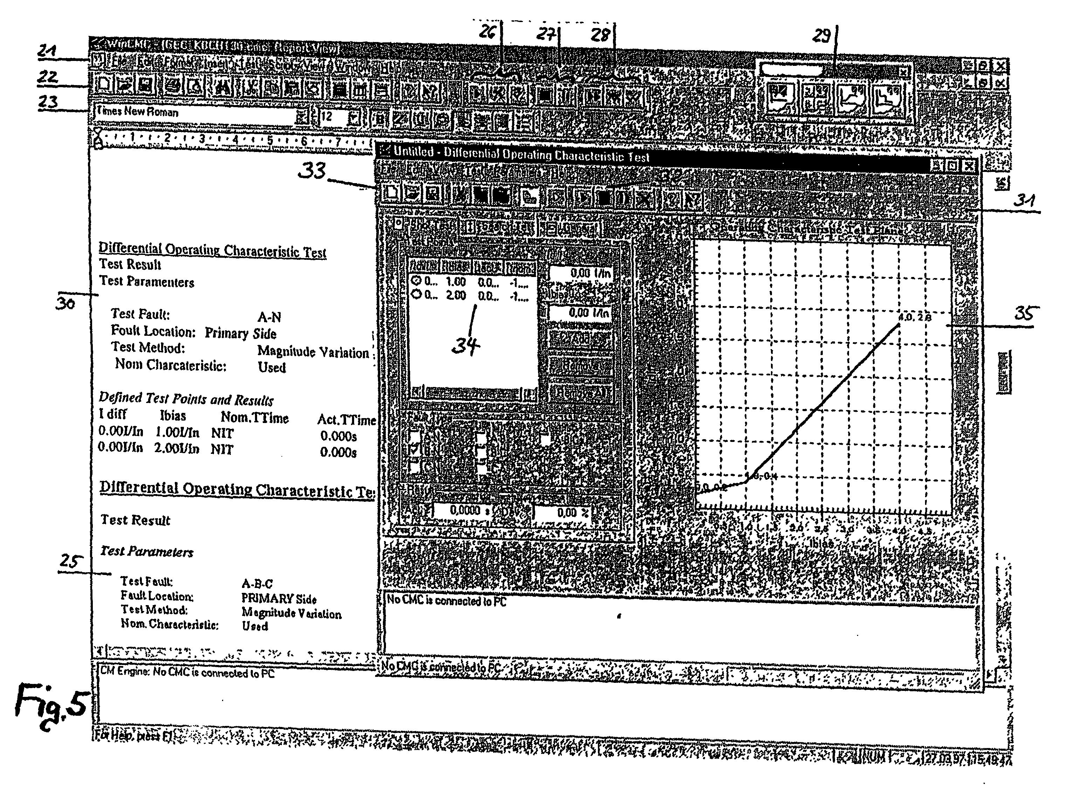

Nachfolgend wird daher anhand Fig. 4 und 5 ein bevorzugtes Ausführungsbeispiel der vorliegenden Erfindung anhand einer graphischen Benutzeroberfläche erläutert, welche für das 32-Bit Betriebssystem Microsoft-Windows 95 oder Microsoft-Windows NT entwickelt worden ist und auf einer Microsoft-ActiveX/OLE-Implementierung beruht.

Die Benutzeroberfläche besitzt zunächst eine Menüleiste 21, welche die für Windows-Anwendungen üblichen Menübefehle bereitstellt Insbesondere können über diese Menüleiste erstellte Testvorschriften bzw. Prüfdokumente gespeichert, geladen, gedruckt, neu erstellt, geändert, formatiert usw. werden. Über den Menüpunkt "Insert" kann ein neues Testmodul in eine Testvorschrift eingefügt werden, während über den Menüpunkt "Test" der Test gemäß der erstellten Testvorschrift gestartet, angehalten, unterbrochen bzw. fortgesetzt werden kann. Ebenso können über diesen Menüpunkt bestimmte Testergebnisse gelöscht werden. Über den Menüpunkt "Script" kann die bereits zuvor erwähnte Makro-Programmierung durchgeführt werden, während über den Menüpunkt "View" zwischen unterschiedlichen Ansichten, wie beispielsweise einer sogen. Icon-Ansicht oder einer Listenansicht, der eingebetteten Testmodule umgeschaltet werden kann. Über den Menüpunkt "Windows" bzw. "Help" können die dargestellten Fenster angeordnet bzw. eine Hilfefunktion aufgerufen werden.

Unterhalb der Menüleiste 21 sind für die wesentlichen zuvor beschriebenen Menübefehle Buttons dargestellt, die somit einen vereinfachten Zugriff auf die wichtigen Menübefehle ermöglichen. Des weiteren sind darunter Einstellfelder bzw. Formatierbuttons 23 dargestellt, welche insbesondere zur Formatierung eines eingegebenen Textes bzw. einer eingebetteten Grafik dienen.

Das Steuermodul überwacht dynamisch sämtliche verfügbaren Testmodule, die insbesondere in Form einer Datenbank in dem Testsystem abgelegt sind. Die verfügbaren Testmodule werden ständig in einem Feld 29 angezeigt. Auf diese Weise können wahlweise neue Testmodule nachgerüstet werden, die automatisch erkannt und sofort dem Benutzer über das Feld 29 zur Verfügung gestellt werden.

Das Feld 25 stellt die von dem Benutzer erstellte Testvorschrift bzw. das von dem Benutzer erstellte Prüfdokument dar. In dieses Feld kann der Benutzer beliebigen Text eingeben oder Grafiken einbetten sowie Verbindungen zu anderen Standarddateien herstellen. Ein Testmodul wird aus dem Testmodulbereich 29 ausgewählt, in dem mit dem Mauszeiger ein dem Testmodul entsprechendes Symbol angeklickt und an der augenblicklichen Position des Cursors in dem Feld 25 eingefügt wird. Das Testmodul wird sofort in Form einer entsprechenden Protokollansicht dargestellt, welche die (zunächst nicht vorhandenen) Testergebnisse des entsprechenden Testmoduls sowie gegebenenfalls auch die entsprechenden Testgeräte- und Prüflingsparameterinformationen wiedergibt.

Oberhalb des eigentlichen Testvorschriftfeldes 25 ist ein weiteres Feld bzw. Fenster 24 geöffnet, welches in Listenform sämtliche von dem Benutzer bisher ausgewählte Testmodule darstellt, wobei die einzelnen Testmodule individuell für einen nachfolgenden Test über die mit Haken versehenen Kästchen aktiviert und ausgewählt werden können.

In dem Listenfeld 24 werden die ausgewählten Testmodule zusammen mit dem augenblicklichen Status des entsprechenden Testmoduls sowie eine Information über die für das entsprechende Testmodul erforderliche Testgerätekonfiguration dargestellt.

Im oberen Bereich der in Fig. 4 gezeigten graphischen Benutzeroberfläche sind Buttons 26 dargestellt, über die ein bestimmtes Testmodul, welches in dem Listenfeld 24 hervorgehoben dargestellt ist, individuell gestartet werden kann sowie die diesem Testmodul entsprechenden Testergebnisse gelöscht werden können und die für die Ausführung dieses Testmoduls erforderliche Testgerätekonfiguration überprüft, d.h. verifiziert werden kann.

Daneben sind Buttons 27 dargestellt, mit denen sowohl ein einzeln ablaufendes Testmodul sowie der Gesamttest abgebrochen oder angehalten werden kann.

Schließlich sind auch Buttons 28 dargestellt, wodurch ein Test sämtlicher eingebetteter Testmodule in der von dem Benutzer ausgewählten Reihenfolge, ein Löschen sämtlicher Testergebnisse sowie eine Überprüfung der für sämtliche Testmodule erforderlichen Testgerätekonfiguration möglich ist.

Wie bereits zuvor beschrieben worden ist, wird nach Auswählen eines neuen Testmoduls aus dem Testmodulbereich 29 automatisch eine Eingabemaske geöffnet, die ein Einstellen der für die Durchführung des entsprechenden Testmoduls erforderlichen Testparameter ermöglicht. Dieser Zustand ist in Fig. 5 dargestellt.

Die in Fig. 5 dargestellte Eingabemaske 31 enthält wiederum eine Menüleiste, über die die einzelnen Eigenschaften des Testmoduls geladen oder verändert werden können. Die wesentlichen Menüpunkte sind in einer Buttonleiste 33 wiederum zusammengefaßt. Des weiteren enthält diese Eingabemaske Buttons 32, über die das individuelle Testmodul einzeln, d.h. getrennt von dem Gesamttest, durchgeführt sowie abgebrochen und angehalten werden kann. Des weiteren können über einen dieser Buttons die Testergebnisse des entsprechenden Testmoduls gelöscht werden. Zudem ist es möglich, das Testmodul auch ohne Erstellung eines Test- bzw. Prüfberichts durchzuführen, was insbesondere für die Fehlersuche hilfreich ist.

In einem Feld 35 der Eingabemaske 31 ist die dem Testmodul eigene Kennlinie zwischen dem Differentialstrom und dem Stabilisierungsstrom für einen elektrischen Prüfling einer Energieversorgungseinrichtung dargestellt. Der Benutzer hat nunmehr durch Anklicken eines beliebigen Punktes innerhalb des Kennlinienfeldes 35 die Möglichkeit, den entsprechenden Punkt als Testpunkt für die Durchführung des Testmoduls auszuwählen, wobei der entsprechende Testpunkt in ein Anzeigenfeld 34 übernommen wird. Durch die neben diesem Anzeigenfeld dargestellten Buttons können einzelne oder sämtliche Testpunkte wieder entfernt werden. Unterhalb des Anzeigenfeldes kann die Testart für den durch das Testmodul durchzuführenden Test festgelegt werden, wobei beispielhaft ein Dreiphasensystem geprüft werden kann, wobei die drei Phasen durch A, B und C und die Erde durch N abgekürzt werden. Durch Auswählen des Feldes "B-N" wird dementsprechend ein Fehler zwischen der zweiten Phase und Erde überprüft. Darunter wird hinsichtlich eines gewählten Testpunkts die tatsächlich gemessene Ansprechzeit sowie die sich daraus ergebende Abweichung wiedergegeben.

In dem Anzeigenfeld 34 werden zudem für jeden ausgewählten Testpunkt nach Durchführen eines Tests die gemessene Ansprechzeit "t_{act}" und die vorgegebene Ansprechzeit "tₙₒᵣₘ" angezeigt.

Sowohl in Fig. 4 als auch in Fig. 5 werden für den Benutzer nicht verfügbare Buttons, z.B. der Testbutton vor Speichern oder Löschen bestehender Testergebnisse, grau dargestellt.

Innerhalb der Eingabemaske 31 kann zwischen unterschiedlichen Ansichten zur Eingabe verschiedener Testparameter für das ausgewählte Testmodul umgeschaltet werden. Des weiteren ist es auch möglich, zwischen der in Fig. 5 dargestellten Eingabemaske 31 sowie der ebenfalls in Fig. 5 dargestellten Testberichtansicht umzuschalten, wobei das Testberichtfeld 25 mit der eigentlichen Testvorschrift vorzugsweise ständig im Hintergrund dargestellt wird. Das über die Eingabemaske 31 augenblicklich bearbeitete Testmodul wird innerhalb der Testvorschrift 25 (wie durch das Bezugszeichen 30 angedeutet) hervorgehoben dargestellt.

## Patentansprüche

1. Testsystem zum Testen der Funktionsfähigkeit von elektrischen Bestandteilen von Energieversorgungseinrichtungen, mit Eingabemitteln (9) zum Erstellen einer benutzerspezifschen Testvorschrift (13), mit mehreren unterschiedlichen Testmodulen (2a-2c) zum Testen eines Prüflings (7), und mit einem Steuermodul (1), welches die Testmodule (2a-2c) gemäß der über die Eingabemittel (9) erstellten benutzerspezifischen Testvorschrift ansteuert und somit aktiviert und automatisch einen Testbericht über die Ergebnisse der Einzeltests der gemäß der Testvorschrift (13) angesteuerten Testmodule (2a-2c) erstellt,
wobei die Testmodule (2a-2c) und die Eingabemittel (9) derart ausgestaltet sind, daß zur Erstellung der benutzerspezifischen Testvorschrift (13) über die Eingabemittel (9) einzelne der Testmodule (2a-2c) durch einen Benutzer derart auswählbar und miteinander kombinierbar sind, daß von den durch das Steuermodul (1) gemäß der Testvorschrift (13) angesteuerten Testmodulen (2a-2c) nacheinander unterschiedliche Funktionsaspekte eines Prüflings (7) oder unterschiedliche Punktionsaspekte unterschiedlicher Prüflinge (7) getestet werden,
**dadurch gekennzeichnet,**
**daß** das Steuermodul (1) automatisch den Testbericht in die Testvorschrift (13) einfügt und die Testvorschrift (13) mit dem darin eingefügten Testbericht zusammen mit sämtlichen für die Durchrührung des der Testvorschrift (13) entsprechenden Tests erforderlichen Parameterdaten in Speichermitteln (10) Speichert, und dass Löschmittel (8) zum Löschen einzelner oder sämtlicher Testergebnisse innerhalb der Testvorschrift (13) zur erneuten Durchführung eines Tests mit den Testmodulen, für welche die Testergebnisse gelöscht worden sind, vorgesehen sind.

2. Testsystem nach Anspruch 1,
**dadurch gekennzeichnet,**
**daß** die Erstellung der benutserspezifischen Testvorschrift (13) rechnergestützt über eine graphische Benutzeroberfläche erfolgt.

3. Testsystem nach einem der vorhergehenden Ansprüche,
**dadurch gekennzeichnet,**
**daß** das Steuermodul (1) automatisch alle verfügbaren Testmodule (2a - 2c) ermittelt und anzeigt.

4. Testsystem nach einem der vorhergehenden Ansprüche,
**dadurch gekennzeichnet,**
**daß** in die benutzerspezifische Testvorschrift (13) Texte (14, 16, 18), Grafiken (15) und/oder Dateien mit entsprechenden Datenformaten einbindbar sind.

5. Testsystem nach einem der vorhergehenden Ansprüche,
**gekennzeichnet durch**
Programmiermittel (11), um bestimmte Abläufe des Steuermoduls (1) oder eines Testmoduls (2a - 2c) benutzerspezifisch zu automatisieren.

6. Testsystem nach einem der vorhergehenden Ansprüche,
**gekennzeichnet durch**
zentrale Prüflingsparameter-Speichermittel (3) zum Speichern und Verwalten von prüflingsbezogenen Daten, welche Eigenschaften der zu testenden Prüflinge (7) beschreiben, wobei das Steuermodul (1) und/oder die Testmodule (2a - 2c) auf die in den zentralen Prüflingsparameter-Speichermitteln (3) gespeicherten prüflingsbezogenen Daten zugreifen.

7. Testsystem nach Anspruch 6,
**dadurch gekennzeichnet,**
**daß** die prüflingsbezogenen Daten eingebbar und/oder austauschbar sind.

8. Testsystem nach einem der vorhergehenden Ansprüche,
**gekennzeichnet durch**
zentrale Testgeräteparameter-Speichermittel (4) zum Speichern und Verwalten von testgerätebezogenen Daten, welche Eigenschaften von **durch** die Testmodule (2a - 2c) angesteuerten Testgeräten (6) beschreiben, welche zum Testen des oder der Prüflinge (7) vorgesehen sind, wobei das Steuermodul (1) und/oder die Testmodule (2a - 2c) auf die in den zentralen Testgeräteparameter-Speichermitteln (4) gespeicherten testgerätebezogenen Daten zugreifen.

9. Testsystem nach Anspruch 8,
**dadurch gekennzeichnet,**
**daß** die testgerätebezogenen Daten bei Inbetriebnahme des Testsystems automatisch durch Überprüfen der an das Testsystem angeschlossenen Testgeräte (6) erzeugt werden und/oder von einem Benutzer eingebbar sind.

10. Testsystem nach Anspruch 9,
**dadurch gekennzeichnet,**
**daß** das Testsystem vor Ausführung der benutzerspezifischen Testvorschrift (13) anhand der in den zentralen Testgeräteparameter-Speichermitteln (4) gespeicherten testgerätebezogenen Daten feststellt, ob die zur Verfugung stehenden Testgeräte (6) für die Ausführung der Testvorschrift (13) geeignet sind.

11. Testsystem nach einem der vorhergehenden Ansprüche,
**dadurch gekennzeichnet,**
**daß** das Steuermodul (1) nach Erstellen der benutzerspezifischen Testvorschrift (13) Informationen (15) über die Verdrahtung des Testsystems mit dem zu testenden Prüfling (7) anzeigt.

12. Testsystem nach einem der vorhergehenden Ansprüche,
**dadurch gekennzeichnet,**
**daß** das Steuermodul (1) Zustandsinformationen von den Testmodulen (2a - 2c) erhält, die den Zustand der Testmodule (2a - 2c) beschreiben, und die Zustandsinforaiationen über entsprechende Wiedergabemittel (12) wiedergibt.

13. Testsystem nach einem der vorhergehenden Ansprüche,
**dadurch gekennzeichnet,**
**daß** bestimmte Funktionen des Steuermoduls (1) und/oder der Testmodule (2a - 2c) durch einen benutzerspezifischen Zugriffscode geschützt sind.

14. Verfahren zum Testen der Funktionsfähigkeit von elektrischen Bestandteilen von Energieversorgungseinrichtungen, umfassend die Schritte
a) Bereitstellen mehrerer unterschiedlicher Testmodule (2a - 2c) zum Testen eines elektrischen Prüfings (7),
b) Erstellen einer benutzerspezifischen Testvorschrift (13),
c) Testen eines Prüflings (7) gemäß der im Schritt b) erstellten Testvorschrift (13), und
d) Automatisches Erstellen eines Testberichts über die Ergebnisse der Einzeltests der gemäß der Testvorschrift (13) angesteuerten Testmodule (2a-2c),
wobei im Schritt b) zur Erstellung der benutzerspezifischen Testvorschrift (13) einzelne der im Schritt a) bereitgestellten Testmodule (2a-2c) derart ausgewählt und miteinander kombiniert werden, daß im Schritt c) von den ausgewählten und gemäß der Testvorschrift (13) angesteuerten Testmodulen (2a-2c) unterschiedliche Funktionsaspekte eines Prüflings (7) oder verschiedener Prüflinge (7) getestet werden,
**dadurch gekennzeichnet,**
**daß** der Testbericht automatisch in die Testvorschrift (13) eingefügt wird,
**daß** die Testvorschrift (13) mit dem darin eingefügten Testbericht zusammen mit allen für die Ausführung der durch die Testvorschrift (13) ausgewählten Testmodule (17, 19) erforderlichen Parameterdaten abgespeichert wird, und
**daß** die gespeicherte Testvorschrift (13) nach Löschen einzelner oder Sämtlicher Testergebnisse innerhalb der Testvorschrift (13) für einen neuen Testvorgang mit den Testmodulen, für welche die Testergebnisse gelöscht worden sind, wiederverwendet wird.

15. Verfahren nach Anspruch 14,
**dadurch gekennzeichnet,**
**daß** im Schritt b) ein ausgewähltes Testmodul (17, 19) automatisch in die gespeicherte Testvorschrift (13) eingefügt wird.

16. Verfahren nach Anspruch 14 oder 15,
**dadurch gekennzeichnet,**
**daß** nach Auswahl eines bestimmten Testmoduls (17, 19) für die Testvorschrift (13) die Testparameter für das ausgewählte Testmodul eingestellt werden.

## Claims

1. Test system for testing the operability of electrical components of energy supply devices,
having input means (9) for producing a user-specific test specification (13),
having a plurality of different test modules (2a-2c) for testing a test sample (7), and
having a control module (1) which controls and thus sequentially activates the test modules (2a-2c) in accordance with the user-specific test specification produced with the aid of the input means (9) and automatically produces a test report on the test results of the individual tests of the test modules (2a-2c) controlled in accordance with the test specification (13),
the test modules (2a-2c) and the input means (9) being arranged such that for the production of the user-specific test specification (13) individual ones of the test modules (2a-2c) are selectable by a user and combinable with each other through the input means (9) in such a way that different functional aspects of the test sample (7) or different functional aspects of different test samples (7) are sequentially tested by the test modules (2a-2c) controlled by the control module (1) in accordance with the test specification (13),
**characterized in that**
the control module (1) automatically inserts the test report into the user-specific test specification (13) and stores the test specification (13) with the test report inserted therein together with all parameter data necessary for the carrying out of the tests corresponding to the test specification (13) in memory means (10), and
deletion means (8) for deleting individual or all test results within the test specification (13) for a new carrying out of a test with those test modules for which the test results have been deleted are provided.

2. Test system according to claim 1,
**characterized in that**
the production of the user-specific test specification (13) is effected computer-aided via a graphical user-interface.

3. Test system according to any one of the preceding claims,
**characterized in that**
the control module (1) automatically detects and displays all available test modules (2a-2c).

4. Test system according to any one of the preceding claims,
**characterized in that**
texts (14, 16, 18), graphics (15) and/or data files having respective data formats can be embedded into the user-specific test specification (13).

5. Test system according to any one of the preceding claims,
**characterized by**
programming means (11) for user-specifically automating particular procedures of the control module (1) or of a test module (2a-2c).

6. Test system according to any one of the proceeding claims,
**characterized by**
central test sample parameter memory means (3) for storing and administering data relating to test samples, which data describes the properties of the test samples (7) to be tested, whereby the control module (1) and/or the test modules (2a-2c) access the test sample related data stored in the central test sample parameter memory means (3).

7. Test system according to claim 6,
**characterized in that**
the test sample related data can be entered and/or exchanged.

8. Test system according to any one of the preceding claims,
**characterized by**
central test apparatus parameter memory means (4) for storing and administering data relating to test apparatuses, which data describes properties of test apparatuses (6) controlled by means of the test modules (2a-2c), which test apparatuses are provided for the testing of the test sample or test samples (7), whereby the control module (1) and/or the test modules (2a-2c) access the test apparatus related data stored in the central test apparatus parameter memory means (4).

9. Test system according to claim 8,
**characterized in that**
the test apparatus related data is automatically generated upon bringing into operation of the test system by means of checking the test apparatuses (6) connected to the test system and/or the data can be entered by user.

10. Test system according to claim 9,
**characterized in that**
before the carrying out of the user-specific test specification (13) the test system determines on the basis of the test apparatus related data stored in the central test apparatus memory means (4) whether the test apparatuses (6) available are suitable for the carrying out the specification (13).

11. Test system according to any one of the preceding claims,
**characterized in that** after production of the user-specific test specification (13), the control module (1) displays information (15) concerning the cabling of the test system with the test sample (7) to be tested.

12. Test system according to any one of the preceding claims,
**characterized in that**
the control module (1) receives condition information from the test modules (2a-2c), which condition information describes the condition of the test modules (2a-2c), and reproduces the condition information by means of appropriate reproducing means (12).

13. Test system according to any one of the preceding claims,
**characterized in that**
particular functions of the control module (1) and/or of the test modules (2a-2c) are protected by a user-specific access code.

14. Method for testing the operability of electrical components of energy supply devices,
comprising the steps
a) providing a plurality of different test modules (2a-2c) for testing an electrical test sample (7),
b) producing a user-specific test specification (13),
c) testing a test sample (7) in accordance with the test specification produced in step b), and
d) producing automatically a test report on the test results of the individual tests of the test modules (2a-2c) controlled in accordance with the test specification (13), individual ones of the test modules (2a-2c) provided in step a) being selected and combined with each other in step b) for the production of the user-specific test specification (13) in such a way that in step c) different functional aspects of a test sample (7) or of different test samples (7) are tested by the test modules (2a-2c) selected and controlled in accordance with the test specification (13),
**characterized in that**
the test report is automatically inserted in the test specification (13),
the test specification (13) is stored with the test report inserted therein together with all parameter data necessary for the carrying out of the test modules (17, 19) selected by the test specification (13), and
after deletion of individual or all test results within the test specification (13), the stored test specification (13) is employed again for a new test process with those test modules for which the test results have been deleted.

15. Method according to claim 14,
**characterized in that**
in step b) a selected test module (16, 19) is automatically inserted into the stored test specification (13).

16. Method according to claim 14 or 15,
**characterized in that**
after selection of a particular test module (17, 19) for the test specification (13), the test parameters for the selected test module are set.

## Revendications

1. Système de test pour tester le bon fonctionnement de composants électriques de dispositifs d'alimentation en énergie avec des moyens d'entrée (9) pour l'élaboration d'une spécification de test (13) spécifique à l'utilisateur, comprenant plusieurs modules de test (2a-2c) pour tester un échantillon (7) et un module de commande (1), qui amorce et donc active les modules de test (2a-2c) selon la spécification de test spécifique à l'utilisateur et établit automatiquement un rapport de test sur les résultats des tests individuels des modules de test (2a-2c) amorcés selon la spécification de test (13),
les modules de test (2a-2c) et les moyens d'entrée (9) étant conçus de telle façon que, pour établir la spécification de test (13) spécifique à l'utilisateur à l'aide des moyens d'entrée (9), certains des modules de test (2a-2c) peuvent être sélectionnés par un utilisateur et combinés entre eux de telle façon que les modules de test (2a-2c) amorcés par le module de commande (1) selon la spécification de test (13) testent de façon successive différents aspects de fonction d'un échantillon (7) ou différents aspects de fonction de différents échantillons (7),
**caractérisé en ce que** le module de commande (1) insère automatiquement le rapport de test dans la spécification de test (13)
et la spécification de test (13) mémorise dans des moyens de stockage (10) la spécification de test (13) avec le rapport de test inséré dedans en même temps que toutes les données de paramètres nécessaires pour l'exécution des tests correspondant à la spécification de test (13) et **en ce que** des moyens d'effacement (8) prévus pour effacer certains résultats de tests ou l'ensemble des résultats de tests dans le cadre de la spécification de test (13) pour la nouvelle exécution d'un test avec les modules de test pour lesquels les résultats de test ont été effacés.

2. Système de test selon la revendication 1,
**caractérisé**
**en ce que** l'établissement de la spécification de test (13) spécifique à l'utilisateur s'effectue de façon automatisée par l'intermédiaire d'une interface utilisateur graphique.

3. Système de test selon l'une quelconque des revendications précédentes,
**caractérisé**
**en ce que** le module de commande (1) détermine automatiquement tous les modules de test (2a-2c) disponibles et les affiche.

4. Système de test selon l'une quelconque des revendications précédentes,
**caractérisé en ce que** des textes (14, 16, 18), des graphiques (15) et/ou des fichiers avec des formats de données appropriés peuvent être intégrés dans la spécification de test (13) spécifique à l'utilisateur.

5. Système de test selon l'une quelconque des revendications précédentes,
**caractérisé par**
des moyens de programmation (11) afin d'automatiser de façon spécifique à l'utilisateur certaines séquences du module de commande (1) ou d'un module de test (2a-2c).

6. Système de test selon l'une quelconque des revendications précédentes,
**caractérisé par**
des moyens centralisés de stockage de paramètres d'échantillons (3) pour le stockage et la gestion de données spécifiques à l'échantillon, qui décrivent des propriétés des échantillons (7) à tester, le module de commande (1) et/ou les modules de test (2a-2c) ayant recours aux données spécifiques à l'échantillon et mémorisées dans les moyens centralisés de stockage de paramètres d'échantillons.

7. Système de test selon la revendication 6,
**caractérisé**
**en ce que** les données spécifiques à l'échantillon peuvent être entrées et/ou remplacées.

8. Système de test selon l'une quelconque des revendications précédentes,
revendiqué par
des moyens centralisés de stockage de paramètres d'appareils de test (4) pour le stockage et la gestion de données spécifiques aux appareils de test, qui décrivent des propriétés d'appareils de test (6) commandés par les modules de test (2a-2c), qui sont prévus pour le test de l'échantillon ou des échantillons (7), le module de commande (1) et/ou les modules de test (2a-2c) ayant recours aux données spécifiques aux appareils de test et stockées dans les moyens centralisés de stockage des paramètres d'appareils de test (4).

9. Système de test selon la revendication 8,
**caractérisé**
**en ce que** les données spécifiques aux appareils de test sont générées lors de la mise en service du système de test automatiquement par le contrôle des appareils de test (6) raccordés au système de test et/ou peuvent être entrés par un utilisateur.

10. Système de test selon la revendication 9,
**caractérisé**
**en ce que** le système de test détermine avant l'exécution de la spécification de test (13) spécifique à l'utilisateur à l'aide des données spécifiques aux appareils de test et mémorisées dans les moyens centralisés de stockage des paramètres des appareils de test (4) si les appareils de test (6) mis à disposition conviennent pour l'application de la spécification de test (13).

11. Système de test selon l'une quelconque des revendications précédentes,
**caractérisé**
**en ce que** le module de commande (1) affiche après l'élaboration de la spécification de test (13) spécifique à l'utilisateur des informations (15) sur le câblage du système de test avec l'échantillon à tester (7).

12. Système de test selon l'une quelconque des revendications précédentes,
**caractérisé**
**en ce que** le module de commande (1) reçoit des informations d'état des modules de test (2a-2c) qui décrivent l'état des modules de test (2a-2c) et restituent les informations d'état par l'intermédiaire de moyens de restitution appropriés.

13. Système de test selon l'une quelconque des revendications précédentes,
**caractérisé**
**en ce que** certaines fonctions du module de commande (1) et/ou des modules de test (2a-2c) sont protégées par un code d'accès spécifique à l'utilisateur.

14. Procédé pour tester le bon fonctionnement de composants électriques de dispositifs d'alimentation en énergie comprenant les étapes suivantes
a) mise à disposition de plusieurs modules de test (2a-2c) différents pour tester un échantillon électrique (7),
b) élaboration d'une spécification de test (13) spécifique à l'utilisateur,
c) test d'un échantillon (7) selon la spécification de test (13) établie à l'étape b), et
d) élaboration automatique d'un rapport de test sur les résultats des tests individuels des modules de test (2a-2c) commandés selon la spécification de test (13),
moyennant quoi certains des modules de test (2a-2c) mis à disposition à l'étape a) peuvent être sélectionnés et combinés entre eux à l'étape b) pour l'élaboration de la spécification de test (13) spécifique à l'utilisateur de telle façon que différents aspects de fonction d'un échantillon (7) ou d'échantillons (7) différents soient testés à l'étape c) par les modules de test (2a-2c) sélectionnés et commandés selon la spécification de test (13),
**caractérisé**
**en ce que** le rapport de test est inséré automatiquement dans la spécification de test (13),
**en ce que** la spécification de test (13) est mémorisée avec le rapport de test inséré dedans et mémorisé en même temps que toutes les données de paramètres nécessaires pour la réalisation des modules de test (17, 19) sélectionnés par la spécification de test (13), et
**en ce que** la spécification de test (13) mémorisée est réutilisée après l'effacement de certains ou de l'ensemble des résultats de test dans le cadre de la spécification de test (13) pour une nouvelle opération de test, avec les modules de test, pour lesquels les résultats de test ont été effacés.

15. Procédé selon la revendication 14,
**caractérisé**
**en ce qu'**un module de test (17, 19) sélectionné est inséré automatiquement dans la spécification de test (13) mémorisée à l'étape b).

16. Procédé selon la revendication 14 ou 15,
**caractérisé**
**en ce que** les paramètres de test sont réglés pour le module de test sélectionné après le choix d'un module de test (17, 19) défini pour la spécification de test (13).
